(19) Europäisches Patentamt
European Patent Office
Office européen des brevets

(11) **EP 4 653 386 A1**

(12) **EUROPEAN PATENT APPLICATION**
published in accordance with Art. 153(4) EPC

(43) Date of publication:
**26.11.2025 Bulletin 2025/48**

(21) Application number: **23917710.8**

(22) Date of filing: **14.12.2023**

(51) International Patent Classification (IPC):
***B81B 1/00*** (2006.01)    ***B01J 19/00*** (2006.01)
***B29C 65/48*** (2006.01)    ***B81C 1/00*** (2006.01)
***G01N 37/00*** (2006.01)

(52) Cooperative Patent Classification (CPC):
**B01J 19/00; B29C 65/48; B81B 1/00; B81C 1/00;
G01N 37/00**

(86) International application number:
**PCT/JP2023/044938**

(87) International publication number:
**WO 2024/154499 (25.07.2024 Gazette 2024/30)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **17.01.2023   JP 2023005038
13.07.2023   JP 2023115312**

(71) Applicant: **Toppan Holdings Inc.
Tokyo 110-0016 (JP)**

(72) Inventors:
• **FUKUGAMI, Norihito
  Tokyo 110-0016 (JP)**
• **HAKII, Hidemitsu
  Tokyo 110-0016 (JP)**
• **FURUTA, Kaoru
  Tokyo 110-0016 (JP)**

(74) Representative: **Plasseraud IP
104 Rue de Richelieu
CS92104
75080 Paris Cedex 02 (FR)**

(54)  **MICROCHANNEL CHIP AND METHOD FOR PRODUCING SAME**

(57)    A microchannel chip is provided in which a cover member and a resin layer defining a flow channel have fewer slight gaps present at their interface. The microchannel chip includes a substrate (10), a partition layer (20) provided on the substrate (10) and defining a flow channel (3), and a cover member (30) provided on the surface of the partition layer (20) opposite to the surface in contact with the substrate (10). The cover member (30) is formed from a resin material, and the resin material has a reduced modulus of 1.68 MPa or more and 44.3 MPa or less as measured by nanoindentation.

FIG.2

EP 4 653 386 A1

**Description**

[Technical Field]

The present invention relates to a microchannel chip and a method for producing the same.

[Background Art]

Recently proposed techniques utilize lithography process and thick-film process technologies to create a microscale reaction field, enabling testing on samples ranging from several nL to several μL. Such a technique that uses a microscale reaction field is referred to as μ-TAS (micro total analysis system). For example, μ-TAS is applied in fields such as genetic testing, chromosome testing, cell testing, and drug development or utilized for biotechnology, testing on trace substances in an environment, surveys of the cultivation environment for crops, and genetic testing on crops. The introduction of μ-TAS technology provides significant benefits such as automation, higher speed, higher accuracy, lower cost, promptness, and reduction in environmental impact.

In many cases, μ-TAS uses micrometer-scale channels (microchannels, microfluidic channels) formed on a substrate, and such a substrate is referred to as a chip, a microchip, a microchannel chip, a microfluidic chip, a microfluidic device, or a microchannel device.

Such microchannel chips have conventionally been fabricated using techniques such as injection molding, molding, cutting, or etching. Substrates mainly used for microchannel chips are glass substrates because glass substrates can be easily produced and also allow optical detection. In addition, microchannel chips are being developed using resin materials, which are light, more durable than glass substrates, and inexpensive. Examples of methods for producing a microchannel chip using a resin material include a method for producing a microchannel chip by forming a resin substrate with a flow channel pattern by photolithography and bonding a cover member to the resultant resin substrate. This method can form microscale flow channel patterns, which may be difficult to form using conventional technology.

A relatively common method for bonding a microchannel chip substrate and a cover member together is an adhesion method that uses an adhesive (including a glue, a sealing agent, a double-sided adhesive tape, or a single-sided adhesive tape) having a thickness from a few μm to tens of μm (for example, see PTL 1). However, when an adhesive is used for bonding, leaching of adhesive components or visibility in testing may be an issue depending on the application of the microchannel chip. To address this, there are also provided adhesive-free methods for using a hot press or an ultrasonic welder to join a substrate and a cover member (for example, see PTL 2) and for generating plasma from process gas at or near atmospheric pressure to modify and bond a substrate and the surface of a cover member (for example, see PTL 3).

[Citation List]

[Patent Literature]

   PTL 1: JP 2003-60127 A

   PTL 2: JP 2002-139419 A

   PTL 3: JP 2011-104886 A

[Summary of the Invention]

[Technical Problem]

During the production of a microchannel chip, when a cover member and a substrate including a resin layer with a flow channel pattern are bonded together without an adhesive, slight gaps may occur at their interface between the resin layer and the cover member. Such slight gaps seem to be caused by nm- to μm-scale irregularities present on the surface of the resin layer. More specifically, the surface of the resin layer has minute irregularities or slight protrusions that cause surface roughness, and thus when the cover member is bonded without an adhesive, the irregularities or the protrusions cause slight gaps at the interface between the resin layer and the cover member. Although the size of the slight gaps depends on the flow channel production method or the materials forming the resin layer, it is natural that the size cannot be reduced to zero.

With slight gaps present at the interface between the resin layer and the cover member, liquid may leak from the gaps. The presence of such slight gaps may also cause air bubbles to build up, a fluid (in many cases, some specimen) to be stagnant or turbulent, or a stable flow velocity or internal pressure to be compromised. This may reduce the functionality and performance of the microchannel chip.

Depending on the design of flow channels, when a gap area is large, the gap and the adjacent flow channel are connected, which may result in fluid (specimen) contamination. At worst, the gap area may expand further starting from the gap, causing the fluid (specimen) to leak out of the microchannel chip. Because many of the fluids handled on microchannel chips are body fluids (such as blood) containing bacteria, a virus, or a pathogen or antibacterial drugs tested for effects on them, the leakage of the fluid to the outside of the chip is a significant problem from a biosafety standpoint.

With such slight gaps present in a microchannel chip, the microchannel chip is determined as being defective in an inspection during manufacture, and thus occurrence of slight gaps is a factor that significantly reduces the production yield. If such gaps are undetected during an inspection, the microchannel chip may be defective as described above.

The present invention has been made in view of such circumstances. An object of the invention is to provide a microchannel chip in which a cover member and a resin layer defining a flow channel have fewer slight gaps present at their interface, and a method for producing the microchannel chip.

[Solution to Problem]

A microchannel chip according to an aspect of the present invention includes: a substrate; a partition layer provided on the substrate and defining a flow channel; and a cover member provided on the surface of the partition layer opposite to the surface in contact with the substrate, wherein the cover member is formed from a resin material, and the resin material has a reduced modulus of 1.68 MPa or more and 44.3 MPa or less as measured by nanoindentation.

A microchannel chip according to another aspect of the present invention includes: a substrate; a partition layer provided on the substrate and defining a flow channel; and a cover member provided on the surface of the partition layer opposite to the surface in contact with the substrate, wherein the cover member is formed from a resin material, and the resin material has a hardness of 0.12 MPa or more and 1.94 MPa or less as measured by nanoindentation.

A microchannel chip production method according to still another aspect of the present invention includes: an application step for applying a photosensitive resin to a substrate; an exposure step for exposing the applied photosensitive resin; a development step for developing and cleaning the exposed photosensitive resin to form a partition layer defining a flow channel on the substrate; and a bonding step for bonding a cover member to the surface of the partition layer opposite to the surface in contact with the substrate, wherein the cover member is formed from a resin material, and the resin material has a reduced modulus of 1.68 MPa or more and 44.3 MPa or less as measured by nanoindentation.

A microchannel chip production method according to still another aspect of the present invention includes: an application step for applying a photosensitive resin to a substrate; an exposure step for exposing the applied photosensitive resin; a development step for developing and cleaning the exposed photosensitive resin to form a partition layer defining a flow channel on the substrate; and a bonding step for bonding a cover member to the surface of the partition layer opposite to the surface in contact with the substrate, wherein the cover member is formed from a resin material, and the resin material has a hardness of 0.12 MPa or more and 1.94 MPa or less as measured by nanoindentation.

[Advantageous Effects of the Invention]

The present invention can provide a microchannel chip in which a cover member and a resin layer defining a flow channel have fewer slight gaps present at their interface.

[Brief Description of the Drawings]

Fig. 1 is a plan view illustrating the structure of a microchannel chip according to first and second embodiments.

Fig. 2 is a cross-sectional view illustrating the structure of the microchannel chip according to the first and second embodiments.

Fig. 3 is a partial enlarged cross-sectional view illustrating the structure of the microchannel chip according to the first and second embodiments.

Fig. 4 illustrates a microchannel chip production method according to the first and second embodiments.

Fig. 5 is a partial enlarged cross-sectional view illustrating the structure of a conventional microchannel chip.

Fig. 6 shows a load-displacement curve used to calculate the degree of stress relaxation.

[Description of the Embodiments]

An embodiment of the present invention will now be described. The present embodiment is a mere example of the present invention, and the present invention is not limited to the present embodiment. The present embodiment may be altered or modified in various ways, and such altered or modified versions can also fall within the scope of the present invention.

The present inventors have conducted research to find that when a cover member and a resin layer defining a flow channel (hereinafter also referred to as a partition layer) are bonded together without an adhesive, the reduced modulus or the hardness of the resin material forming the cover member is important in order to reduce the likelihood that slight gaps will form at the interface between the cover member and the resin layer with nm- to μm-scale irregularities on its surface.

In cases where the reduced modulus or the hardness of the resin material forming the cover member is too high, when the resin layer and the cover member are bonded together without an adhesive, the deformation in the surface of the cover member cannot sufficiently conform to the shape of the surface irregularities of the resin layer, and slight gaps are likely to form. In contrast, in cases where the reduced modulus or the hardness of the resin material forming the cover member is too low, when the resin layer and the cover member are bonded together without an adhesive, the cover member may deform excessively, resulting in a smaller flow channel volume than design specifications or a blockage in the flow channel. In cases where the reduced modulus or the hardness of the resin material forming the cover member is appropriate (i.e., satisfies the conditions described later), when the resin layer and the cover member are bonded together without an adhesive, the surface of the cover member elastically deforms or plastically deforms to conform to the shape of the surface irregularities of the resin layer, and thus formation of slight gaps is suppressed at the interface between the resin layer and the cover member. Furthermore, the cover member and the resin layer are in firm contact.

More specifically, a microchannel chip according to a first embodiment of the present invention includes: a substrate; a partition layer provided on the substrate and defining a flow channel; and a cover member provided on the surface of the partition layer opposite to the surface in contact with the substrate, in which the cover member is formed from a resin material, and the resin material has a reduced modulus of 1.68 MPa or more and 44.3 MPa or less as measured by nanoindentation.

A microchannel chip according to a second embodiment of the present invention includes: a substrate; a partition layer provided on the substrate and defining a flow channel; and a cover member provided on the surface of the partition layer opposite to the surface in contact with the substrate, in which the cover member is formed from a resin material, and the resin material has a hardness of 0.12 MPa or more and 1.94 MPa or less as measured by nanoindentation.

Additionally, a microchannel chip production method according to the first embodiment of the present invention includes: an application step for applying a photosensitive resin to a substrate; an exposure step for exposing the applied photosensitive resin; a development step for developing and cleaning the exposed photosensitive resin to form a partition layer defining a flow channel on the substrate; and a bonding step for bonding a cover member to the surface of the partition layer opposite to the surface in contact with the substrate, in which the cover member is formed from a resin material, and the resin material has a reduced modulus of 1.68 MPa or more and 44.3 MPa or less as measured by nanoindentation.

Additionally, a microchannel chip production method according to the second embodiment of the present invention includes: an application step for applying a photosensitive resin to a substrate; an exposure step for exposing the applied photosensitive resin; a development step for developing and cleaning the exposed photosensitive resin to form a partition layer defining a flow channel on the substrate; and a bonding step for bonding a cover member to the surface of the partition layer opposite to the surface in contact with the substrate, in which the cover member is formed from a resin material, and the resin material has a hardness of 0.12 MPa or more and 1.94 MPa or less as measured by nanoindentation.

For the resin material forming the cover member, only one of the reduced modulus and the hardness measured by nanoindentation needs to satisfy the above conditions, but both may satisfy the above conditions.

Although the partition layer is made from resin, the present invention is applicable to a partition layer made from other materials than resin. For example, the present invention is applicable to a partition layer made from glass, metal, or ceramic.

The microchannel chips according to the first and second embodiments and the microchannel chip production methods according to the first and second embodiments are described in more detail below. The microchannel chips according to the first and second embodiments are the same except for the physical properties (the reduced modulus and the hardness) of the resin material forming the cover member, and thus the microchannel chips according to the first and second embodiments are described collectively. The same applies to the microchannel chip production methods according to the first and second embodiments.

Hereinafter, the substrate of the microchannel chip may be referred to as the bottom, whereas the opposite part (i.e., the cover member) of the microchannel chip facing away from the substrate may be referred to as the top.

(1) Structure of Microchannel Chip

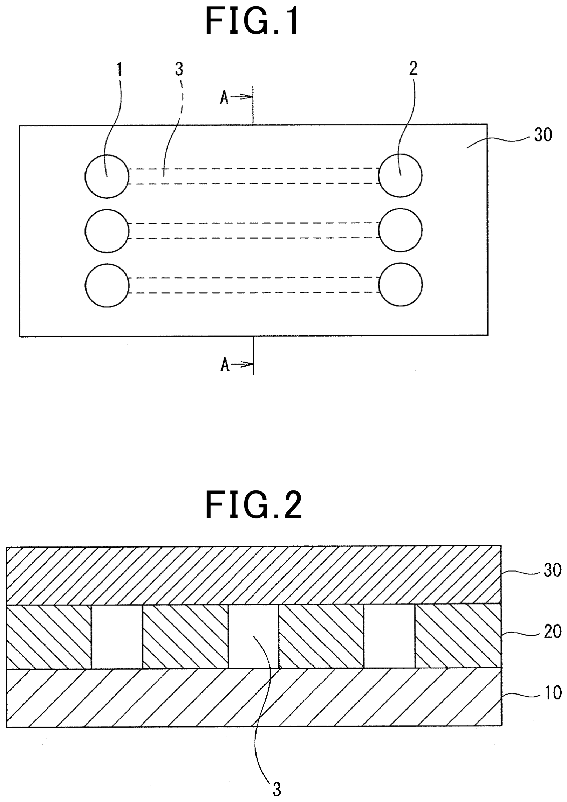

As illustrated in a plan view in Fig. 1 and an A-A cross-sectional view in Fig. 2, a microchannel chip according to the present embodiment includes a substrate 10, a partition layer 20 provided on the substrate 10, and a cover member 30 provided on the surface of the partition layer 20 opposite to the surface in contact with the substrate 10. The microchannel chip according to the present embodiment also includes an inlet 1 for introducing fluid (for example, liquid), a flow channel 3 in which the fluid introduced from the inlet 1 flows, and an outlet 2 for discharging the fluid from the flow channel 3 or the air inside the flow channel 3.

The flow channel 3 is an area surrounded by the substrate 10, the partition layer 20, and the cover member 30 and has a pattern defined by the partition layer 20. The inlet 1 and the outlet 2 are through holes formed in the cover member 30, with the inlet 1 connected to one end of the flow channel 3 and the outlet 2 connected to the other end. The cover member 30 may be transparent to allow the inside of the flow channel 3 to be visible or may be opaque.

In the microchannel chip according to the present embodiment, the inlet 1 and the outlet 2 may each be provided as at least one port or as multiple ports. In the microchannel chip according to the present embodiment, the flow channel 3 may be provided as one channel or as multiple channels. Furthermore, the flow channel 3 may have a pattern that allows confluence and bifurcation of the fluid introduced from the inlet 1.

(2) Substrate

The substrate 10 may be formed from light-transmissive materials or non-light-transmissive materials. For example, to detect and observe the conditions inside the flow channel 3 (the conditions of the fluid) with light, a material highly transparent to the light may be used. Examples of light-transmissive materials include resin and glass. Examples of resins that are light-transmissive materials include acrylic resin, methacrylic resin, polypropylene, polycarbonate, cycloolefin resin, polystyrene, polyester, urethane resin, silicone resin, and fluororesin.

If it is not necessary to detect and observe the conditions inside the flow channel 3 (the conditions of the fluid) with light, a non-light-transmissive material may be used. Examples of non-light-transmissive materials include silicon wafers and copper sheets. Although not limited to a specific thickness, the thickness of the substrate 10 preferably falls within the range of 10 $\mu$m (0.01 mm) or more and 10 mm or less because some rigidity is necessary in the production of a microchannel chip.

(3) Partition Layer

The partition layer 20 may be, for example, formed from resin, such as a photosensitive resin. Examples of photosensitive resins include resins photosensitive to light in the ultraviolet region at wavelengths of 190 nm or more and 400 nm or less. Such photosensitive resins include photoresists such as liquid resists or dry film resists. Either positive photoresist, in which its photosensitive region dissolves, or negative photoresist, in which its photosensitive region becomes insoluble, can be used.

Examples of photosensitive resin compositions suitable for the formation of the partition layer 20 include a radical-polymerizable negative photosensitive resin composition containing an alkali-soluble polymer, an addition-polymerizable monomer, and a photopolymerization initiator.

The photosensitive resin may have any photosensitive basic structure (backbone), such as acrylic resin, acrylic urethane resin (urethane acrylate resin), epoxy resin, polyamide resin, polyimide resin, polyurethane resin, polyester resin, polyether resin, polyolefin resin, polycarbonate resin, polystyrene resin, norbornene resin, or phenol novolac resin. These resins may be used singly or as a mixture or a copolymer of two or more.

In the present embodiment, the resin forming the partition layer 20 is not limited to a photosensitive resin, but for example, a synthetic resin may be used. Examples of synthetic resins include polymethyl methacrylate (PMMA), polycarbonate (PC), polystyrene (PS), polypropylene (PP), cycloolefin polymer (COP), and cycloolefin copolymer (COC).

Although the thickness of the partition layer 20, or the height of the flow channel 3, is not limited to a specific value, the height of the flow channel 3 needs to be greater than the substances for analysis and testing contained in the fluid introduced into the flow channel 3 (e.g., drugs, bacteria, cells, erythrocytes, leukocytes). Accordingly, the thickness of the partition layer 20, or the height of the flow channel 3, is preferably 5 $\mu$m or more and 100 $\mu$m or less.

Similarly, since the flow channel 3 needs to be wider than substances for analysis and testing, the width of the flow channel 3 defined by the partition layer 20 is preferably 5 $\mu$m or more and 1000 $\mu$m or less, and more preferably 5 $\mu$m or more and 100 $\mu$m or less.

Furthermore, in order to achieve the advantageous effects of the present invention sufficiently, the partition layer 20 is preferably harder than the resin materials forming the cover member 30, and thus the resin forming the partition layer 20 preferably has the physical properties described below. That is, it is preferable for the reduced modulus measured by nanoindentation to be 500 MPa or more or for the hardness measured by nanoindentation to be 25 MPa or more.

In addition, as the surface of the partition layer 20 in contact with the cover member 30 becomes smoother, formation of slight gaps is suppressed, and thus the protrusions from the surface of the partition layer 20 in contact with the cover member 30 are preferably small, for example, 10 μm or less.

(4) Cover Member

In the microchannel chip according to the present embodiment, the cover member 30 lies over the flow channel 3, as shown in Fig. 2. The cover member 30 is provided on the surface of the partition layer 20 opposite to the surface in contact with the substrate 10, facing the substrate 10 across the partition layer 20. More specifically, in the cross section shown in Fig. 2, the cover member 30 has side edges supported by the partition layer 20 and a central region facing the substrate 10, and the central region defines the top of the flow channel 3.

Although not limited to a specific thickness, the thickness of the cover member 30 preferably falls within the range of 10 μm (0.01 mm) or more and 10 mm or less, and more preferably 50 μm or more and 2 mm or less, so as to provide the cover member 30 with through holes corresponding to the inlet 1 and the outlet 2. Before being bonded to the partition layer 20, the cover member 30 is desirably provided with the through holes corresponding to the inlet 1 and the outlet 2 for fluid. This can reduce possible waste and contamination problems compared with cases in which the through holes are formed after the bonding to the partition layer 20.

The cover member 30 can be formed from a light-transmissive material or a non-light-transmissive material. For example, to detect and observe the conditions inside the flow channel 3 (the conditions of the fluid) with light, a resin material highly transparent to the light may be used. If it is not necessary to detect and observe the conditions inside the flow channel 3 (the conditions of the fluid) with light, a non-light-transmissive material may be used.

The resin material forming the cover member 30 needs to have the physical properties described below. That is, it is necessary for the reduced modulus of the resin material measured by nanoindentation to be 1.68 MPa or more and 44.3 MPa or less or for the hardness of the resin material measured by nanoindentation to be 0.12 MPa or more and 1.94 MPa or less. Although the resin material is required to satisfy the physical property condition of one of the reduced modulus and the hardness, both the physical property conditions may be satisfied.

For the cover member 30 formed of the resin material having the above-described physical properties, when the partition layer 20 and the cover member 30 are bonded together, the surface of the cover member 30 elastically deforms or plastically deforms to conform to the shape of the surface irregularities of the partition layer 20, and thus slight gaps are suppressed at the interface between the partition layer 20 and the cover member 30. Accordingly, the partition layer 20 and the cover member 30 can be bonded firmly together without an adhesive. Furthermore, since the cover member 30 does not deform excessively, it is unlikely that the deformed cover member 30 will make the volume of the flow channel 3 smaller than the design specification or block the flow channel 3.

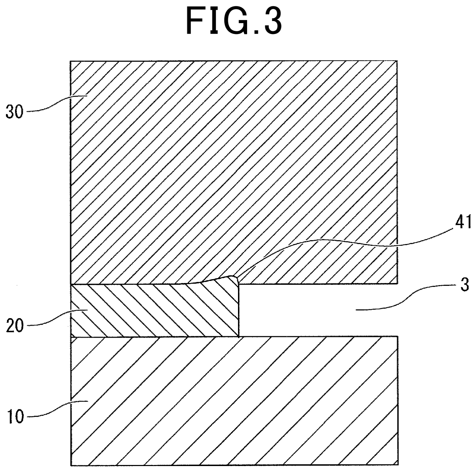

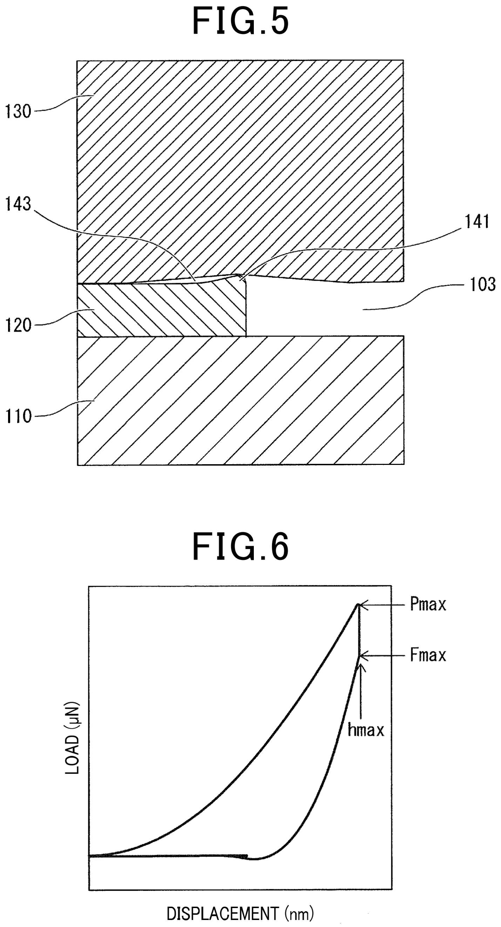

This is described with reference to Figs. 3 and 5. Fig. 3 is a partial enlarged cross-sectional view of Fig. 2. In conventional microchannel chips, when a partition layer 120 has a protrusion 141 from its surface, the deformation in the surface of a cover member 130 cannot sufficiently conform to the protrusion 141 from the surface of the partition layer 120, and a slight gap 143 is likely to form at the interface between the partition layer 120 and the cover member 130 (see Fig. 5). In Fig. 5, reference sign 110 refers to a substrate, while reference sign 103 refers to a flow channel.

In contrast, in the microchannel chip according to the present embodiment, since the resin material forming the cover member 30 satisfies the above-described conditions, the deformation in the surface of the cover member 30 can sufficiently conform to a protrusion 41 from the surface of the partition layer 20, and a slight gap is unlikely to form at the interface between the partition layer 20 and the cover member 30 (see Fig. 3).

Examples of the resin material that forms the cover member 30 include silicone rubbers (for example, polydimethylsiloxane (PDMS)) and synthetic resins. Examples of synthetic resins include acrylic resin, methacrylic resin (for example, polymethyl methacrylate (PMMA)), polypropylene (PP), polycarbonate (PC), polystyrene (PS), cycloolefin polymer (COP), cycloolefin copolymer (COC), polyester (for example, polyethylene terephthalate (PET), polyurethane, polyvinyl chloride, silicone resin, and fluororesin.

The reduced modulus and the hardness of the resin material forming the cover member 30 are those measured by nanoindentation at 25°C. The reduced modulus measured by nanoindentation is a physical property value representing hardness based on the elastic deformation component of the material. The hardness measured by nanoindentation is a physical property value representing hardness based on both the elastic deformation and plastic deformation components of the material. The details of the measurement method are as defined by the International Organization for Standardization (ISO) in International Standard ISO 14577 and will not be described here.

In the microchannel chips according to the first and second embodiments of the present invention and the microchannel chip production methods according to the first and second embodiments of the present invention, for the resin material forming the cover member 30, it is preferable for one or both of the reduced modulus and the hardness measured by nanoindentation to satisfy the above-described conditions and also the degree of stress relaxation measured by nanoindentation to satisfy the condition described below. That is, the degree of stress relaxation of the resin material measured by nanoindentation is preferably 10% or more and 19% or less. The degree of stress relaxation is a parameter that represents the degree of change in stress with respect to a constant strain.

When the degree of stress relaxation of the resin material forming the cover member 30 satisfies the above-described condition, bonding between the partition layer 20 and the cover member 30 by a hot press or other machine is unlikely to cause deformation in the cover member 30, such as warpage. Thus, after the hot press load is released, the stress from the cover member 30 on the partition layer 20 does not relax easily, and accordingly the cover member 30 is unlikely to partially lift. In addition, the distance between the substrate 10 and the cover member 30 across the flow channel 3 can be easily brought to a value close to the designed value (e.g., 95% or more and 105% or less of the designed value). As a result, the microchannel chip in which the height and volume of the flow channel 3 are close to the designed values can be produced easily.

The degree of stress relaxation of the resin material is that measured by nanoindentation at 25°C. A method for measuring the degree of stress relaxation of the resin material is described in detail. A test sample of the resin material is analyzed by the nanoindentation described in International Standard ISO 14577 to obtain a load-displacement curve representing the relationship between the load applied to the test sample and the indentation depth (displacement) (see Fig. 6). The obtained load-displacement curve is used to determine the maximum load in the loading curve (Fmax) and the maximum load in the unloading curve (Pmax), and the determined maximum loads are substituted into the following formula to calculate the degree of stress relaxation.

$$\text{Degree of stress relaxation} = (Fmax - Pmax)/Fmax \times 100 \ (\%)$$

(5) Intermediate Layer

The microchannel chip according to the present embodiment may include an intermediate layer between the substrate 10 and the partition layer 20. That is, the microchannel chip in Figs. 1 and 2 may include the substrate 10, the intermediate layer (not shown) placed on the substrate 10, the partition layer 20 placed on the intermediate layer, and the cover member 30 placed on the partition layer 20.

Examples of the intermediate layer include an adhesive layer that improves the adhesion between the substrate 10 and the partition layer 20 and a light-shielding layer that provides the microchannel chip with light-shielding properties. When glass is used as the substrate 10, the substrate 10 and the partition layer 20 may have an adhesive layer between them.

Examples of the adhesive layer include a hydrophobized surface layer formed by subjecting the surface of the substrate 10 to hydrophobic surface treatment (HMDS treatment) and a thin resin film covering the surface of the substrate 10.

When the microchannel chip according to the present embodiment includes an adhesive layer, the fluid flowing in the flow channel 3 (for example, liquid) is in contact with the adhesive layer instead of the substrate 10. The adhesive layer is thus preferably resistant to the fluid introduced into the flow channel 3. The adhesive layer may be placed on the substrate 10 in order to improve the resolution of the flow channel pattern formed by the photosensitive resin.

(6) Microchannel Chip Production Method

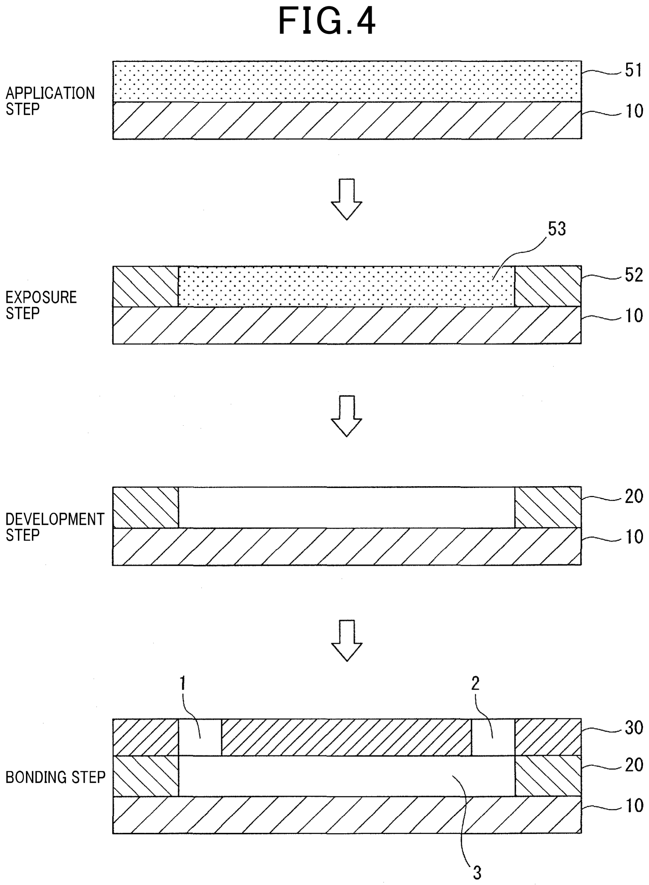

A microchannel chip production method according to the present embodiment will now be described with reference to Fig. 4. In the example described below, the partition layer 20 is formed from a photosensitive resin. Each figure in Fig. 4 is a cross-sectional view of the substrate 10 and the like taken along a plane parallel to the extending direction of the flow channel 3 and perpendicular to the surface of the substrate 10.

The microchannel chip production method according to the present embodiment includes an application step for applying a photosensitive resin to the substrate 10, an exposure step for exposing the applied photosensitive resin, a development step for developing and cleaning the exposed photosensitive resin to form the partition layer 20 defining the flow channel 3 on the substrate 10, and a bonding step for bonding the cover member 30 to the surface of the partition layer 20 opposite to the surface in contact with the substrate 10.

<Application Step>

First, the application step is performed. In the application step, a photosensitive resin layer 51 for forming the partition layer 20 on the substrate 10 is formed on the substrate 10.

Examples of methods for applying photosensitive resin to the substrate 10 include, but are not limited to, spin coating, spray coating, and bar coating. Among these methods, spin coating is preferable from the viewpoint of controllability of coating thickness.

The substrate 10 can be coated with a photosensitive resin in various forms, such as a liquid, a solid, a gel, and a film. In particular, the photosensitive resin layer 51 is preferably formed by liquid resist.

Although the photosensitive resin layer 51 may have any thickness, the thickness of the photosensitive resin layer 51 may be determined before the application of the photosensitive resin so that the formed partition layer 20 has an intended thickness.

When the photosensitive resin contains a solvent, the solvent may be removed from the photosensitive resin layer 51 by a method such as thermal treatment or vacuum treatment.

<Exposure Step>

The application step is followed by the exposure step. That is, the photosensitive resin layer 51 on the substrate 10 is imaged with the pattern of the flow channel 3 by exposure. The light used for the exposure is not limited to a specific type, and ultraviolet radiation or laser can be used. That is, the exposure can be achieved with, for example, an exposure device that emits UV light or a laser writer.

In particular, a proximity exposure device or a contact exposure device that emits UV light is preferably used for the exposure. For a proximity exposure device, the exposure is performed via a photomask carrying the flow channel pattern for the microchannel chip. The photomask may be, for example, a photomask in which a film with a dual-layer structure of chromium and chromium oxide serves as a light-shielding film.

When the photosensitive resin used is a photosensitive resin photosensitive to light in the ultraviolet region at wavelengths of 190 nm or more and 400 nm or less, light in the ultraviolet region at wavelengths of 190 nm or more and 400 nm or less is used for the exposure, and the photosensitive resin is exposed to the light at wavelengths of 190 nm or more and 400 nm or less.

When the photosensitive resin applied to the substrate 10 is a positive resist, the exposed area dissolves to form the flow channel 3, and the photosensitive resin remaining in the unexposed area serves as the partition layer 20. When the photosensitive resin applied to the substrate 10 is a negative resist, the photosensitive resin remaining in the exposed area serves as the partition layer 20, and the unexposed area dissolves to form the flow channel 3.

Fig. 4 illustrates an example in which the photosensitive resin is a negative resist, and reference sign 52 refers to the exposed area, while reference sign 53 refers to the unexposed area.

In this manner, the microchannel chip production method according to the present embodiment can use photolithography to form the partition layer 20 defining the flow channel 3 on the substrate 10.

When a chemically amplified resist is used to form the partition layer 20 on the substrate 10, the exposure may be followed by additional thermal treatment (post-exposure bake: PEB) in order to promote a reaction catalyzed by the acid generated upon the exposure.

<Development Step>

Next, the exposed photosensitive resin is developed to form the pattern of the flow channel 3. The development is performed by, for example, a spray, dip, or puddle development system reacting the photosensitive resin and a developer.

Examples of usable developers include an aqueous solution of sodium carbonate, an aqueous solution of tetramethylammonium hydroxide, an aqueous solution of potassium hydroxide, and an organic solvent. The developer is not limited to those listed above, but any developer suitable for the properties of the photosensitive resin may be selected as appropriate. The concentration of the developer and the development time may be adjusted to conditions suitable for the properties of the photosensitive resin.

The development is followed by cleaning to remove the developer used for the development from the photosensitive resin layer 51 on the substrate 10. Although not limited to a specific method, the cleaning can be performed with a cleaning system of the spray, shower, immersion, or other type. Examples of usable cleaning solutions include pure water and isopropyl alcohol, but a cleaning solution suitable for the removal of the developer used for the development may be selected as appropriate. The cleaning may be followed by drying with a spin dryer or an IPA vapor dryer or by natural drying.

<Surface Modification Step>

After the end of the development step and before the start of the bonding step, one or both of the surface of the partition layer 20 and the surface of the cover member 30 may be modified by surface modification treatment. Examples of surface modification treatments include plasma treatment, ultraviolet (UV) treatment, corona discharge treatment, and excimer laser treatment. The surface modification treatment can add a functional group such as a hydroxy group (-OH) to one or both of the surface of the partition layer 20 and the surface of the cover member 30 to increase the bonding strength between the partition layer 20 and the cover member 30 in the subsequent bonding step.

<Bonding Step>

Next, the cover member 30 is bonded to the surface of the partition layer 20 opposite to the surface in contact with the substrate 10. When the cover member 30 is bonded, the flow channel 3 is covered by the cover member 30 to form the microchannel chip illustrated in Figs. 1 and 2.

The partition layer 20 and the cover member 30 may be bonded together by any method, for example, using an adhesive, and when the resin material forming the cover member 30 has physical properties satisfying requirements in the present invention, the partition layer 20 and the cover member 30 may be bonded together without an adhesive. That is, when the resin material forming the cover member 30 has the above-described physical properties, the flexibility of the surface of the cover member 30 allows the surface of the cover member 30 to elastically deform or plastically deform to conform to the shape of the surface irregularities of the partition layer 20 when the partition layer 20 and the cover member 30 are bonded together. Accordingly, the partition layer 20 and the cover member 30 are in firm contact, and slight gaps are unlikely to form at the interface between the partition layer 20 and the cover member 30.

The partition layer 20 and the cover member 30 may be bonded together under any temperature condition, such as room temperature or a temperature higher than room temperature. The temperature condition may be determined as appropriate based on the above-described physical properties of the resin material forming the cover member 30 or the pressure condition described below. The temperature condition is, for example, preferably a temperature higher than or equal to room temperature and not higher than the heat-resistant temperature of the resin material, more preferably 40°C or more and 200°C or less, and still more preferably 60°C or more and 100°C or less. In the present invention, room temperature refers to 20°C.

The partition layer 20 and the cover member 30 may be bonded together under any pressure condition, and the bonding may be performed without applying pressure to the partition layer 20 and the cover member 30 or with pressure applied to one or both of the partition layer 20 and the cover member 30. The pressure condition may be determined as appropriate based on the above-described physical properties of the resin material forming the cover member 30 or the above-described temperature condition. The pressure condition is, for example, preferably 0.001 Mpa or more and 1 Mpa or less, and more preferably 0.001 Mpa or more and 0.01 Mpa or less. Depending on the physical properties of the resin material forming the cover member 30 or the temperature condition, the cover member 30 may deform under its own weight with no pressure applied, and thus bonding can be achieved with no pressure applied.

When the resin material forming the cover member 30 is polydimethylsiloxane, the temperature condition is preferably 100°C or more and 200°C or less, and the pressure condition is preferably 0.001 Mpa or more and 0.01 Mpa or less.

When the resin material is silicone rubber, the temperature condition is preferably 100°C or more and 200°C or less, and the pressure condition is preferably 0.001 Mpa or more and 0.01 Mpa or less.

When the resin material is polyurethane, the temperature condition is preferably 60°C or more and 100°C or less, and the pressure condition is preferably 0.005 Mpa or more and 0.05 Mpa or less.

When the resin material is polyvinyl chloride, the temperature condition is preferably 20°C or more and 60°C or less, and the pressure condition is preferably 0.005 Mpa or more and 0.05 Mpa or less.

When the resin material is polyethylene terephthalate, polycarbonate, polymethyl methacrylate, or cycloolefin polymer, the temperature condition is preferably 40°C or more and 90°C or less, and the pressure condition is preferably 0.01 Mpa or more and 1 Mpa or less.

Specific examples of methods for bonding the partition layer 20 and the cover member 30 together include thermocompression bonding with a hot press or a hot thermal roll machine. Alternatively, an adhesive may be used to bond the partition layer 20 and the cover member 30 together. The type of the adhesive used can be determined based on, for example, the affinity for the partition layer 20 and the material forming the cover member 30. For example, an acrylic resin-based adhesive, a urethane resin-based adhesive, or an epoxy resin-based adhesive may be used.

Examples

Although the present invention is described in detail below with examples, the present invention is not limited to the examples.

Microchannel chips in Examples 1 to 12 and Comparative Examples 1 to 11 were produced in accordance with the procedure described below.

<Formation of Partition Layer>

First, a square glass substrate measuring 10 cm on each side was coated with a transparent photosensitive resin to form a photosensitive resin layer. The photosensitive resin used is a negative photosensitive resin having an epoxy resin backbone (KMPR 1035 manufactured by Nippon Kayaku Co., Ltd.). The photosensitive resin was applied to the glass substrate using a spin coater. The spin speed and the coating time were adjusted so that the photosensitive resin layer had a coating thickness of 50 $\mu$m, and the spin speed was set to 1700 rpm while the coating time was set to 30 seconds.
Next, a hot plate was used to perform a thermal treatment (pre-bake) in order to remove the solvent contained in the photosensitive resin layer. The pre-bake was performed at a temperature of 90°C for 20 minutes.
Next, the photosensitive resin layer on the glass substrate was exposed to image a flow channel pattern. Specifically, the photosensitive resin layer was patterned by exposure via a photomask carrying the pattern layout of a microchannel. The photomask used was a photomask in which a film with a dual-layer structure of chromium and chromium oxide serves as a light-shielding film. The exposure was performed using a proximity exposure device. The exposure device used includes a high-pressure mercury-vapor lamp as its light source for exposure with broadband wavelengths including the g-, h-, and i-lines. The exposure dose for forming the flow channel pattern was set to 500 mJ/cm$^2$.
Next, the exposed photosensitive resin layer was subjected to a thermal treatment (post-exposure bake: PEB) on the hot plate at 100°C for 240 seconds and then developed to form the flow channel pattern. For the development, an alkaline developer (aqueous solution containing 2.38% by mass of tetramethylammonium hydroxide) is used to develop the photosensitive resin layer for 360 seconds. The development dissolves the unexposed part, forming the flow channel structure by patterning.
Then, a shower rinse was performed with ultrapure water to remove the developer from the photosensitive resin layer on the substrate, followed by drying with a spin dryer, resulting in a partition layer.
The flow channel in the partition layer produced in this process had an opening with a line width of 100 $\mu$m, which is typical for microchannels in drug-resistant bacteria testing chips.

<Observation of Flow Channel Pattern in Partition Layer>

When the produced partition layer was observed and measured with a microscope and a white-light interferometer, the opening width of the flow channel was 100±2 $\mu$m, aligning closely with the design. However, the edge of the partition layer defining the flow channel (the part forming the inner wall of the flow channel) had a slight protrusion (ridge) (see Fig. 3), and the edge was found to be 5 $\mu$m larger in height (thickness) than the flat area other than the edge.
This is a common phenomenon in photolithography. In particular, a negative photosensitive resin experiences high internal tensile stress in the resist due to significant curing shrinkage from crosslinking during exposure and bake. In the flat area of a photosensitive resin, volumetric shrinkage is observed only in the vertical direction because the forces in the lateral direction are balanced. In contrast, since one side of the edge is open, the edge experiences volumetric shrinkage not only in the vertical direction but also in the lateral direction (the direction away from the opening). As a result, it is believed that the edge of the resist of the partition layer is denser than the flat area of the resist, forming the above-described protrusion.

<Cutting>

The glass substrate with the partition layer formed thereon was cut to a size appropriate for microscopic observation. The size is 25 mm in height and 75 mm in width. The resultant section was cleaned with a pure water shower and dried by air blowing.

<Preparation of Cover Member>

Films formed from silicone rubber, polyurethane, polyvinyl chloride, polymethyl methacrylate (PMMA), polyethylene terephthalate (PET), polycarbonates (PC), or cycloolefin polymer (COP), with a thickness of 1.5 mm, were prepared. Then, these films were cut to produce cover members with a height of 25 mm and a width of 75 mm. Additionally, the cover members were punched or machined to create through holes corresponding to the inlet and the outlet, with a diameter of 1 mm.
The silicone rubber belongs to the GSSC series, ultra-transparent silicone rubber sheets, manufactured by TOMITA MATEQS Co., Ltd. The polyurethane belongs to the BM series, urethane resins, manufactured by ADEKA CORPORATION. The polyvinyl chloride belongs to the TK series, vinyl chloride resins, manufactured by Shin-Etsu Chemical Co., Ltd. The polymethyl methacrylate is COMOGLAS (registered trademark), methacrylic resin sheets, manufactured by Kuraray Co., Ltd. The polyethylene terephthalate is KURAPET (registered trademark), polyethylene terephthalate, manufactured by Kuraray Co., Ltd. The polycarbonate is Panlite (registered trademark), polycarbonate resin, manufactured by Teijin Limited. The cycloolefin polymer is ZEONOR (registered trademark), cycloolefin polymer, manufactured by Zeon Corporation.

<Evaluation of Physical Properties of Resin Material>

The physical properties of the resin material forming the cover member, or the reduced modulus, the hardness, and the degree of stress relaxation, were measured by nanoindentation. Nanoindentation refers to a measurement method that conducts a quasistatic indentation test on an intended measurement target to acquire the mechanical properties of the measurement target. The film used for the production of the cover member was cut to produce a square test sample measuring 2 cm on each side, and the test sample was bonded to the sample table in a measurement device using an instant adhesive (Aron Alpha (trade name) manufactured by Toagosei co., Ltd.).

The measurement device used for measuring the reduced modulus, the hardness, and the degree of stress relaxation was a Hysitron TI-Premier (trade name), a nanoindenter, manufactured by Bruker Japan K.K. The indenter used for indentation was a Berkovich diamond indenter manufactured by Bruker Japan K.K.

The measurement by nanoindentation was performed as described below. That is, in the displacement control mode, the indenter was pressed to a depth of 500 nm at an indentation rate of 100 nm/sec, held at the maximum depth for 5 seconds, and then unloaded at a rate of 100 nm/sec. This operation was performed at 30 measurement points on the surface of the test sample. The measurement points were each separated by a distance of 100 $\mu$m or more.

The reduced modulus and the hardness were calculated based on the data obtained from the measurement. That is, the region of the unloading curve ranging from 60% to 95% of the maximum load in the unloading phase was analyzed using the Oliver-Pharr method to calculate the reduced modulus and the hardness. In addition, the load-displacement curve obtained in the above measurement was used to calculate the degree of stress relaxation. The results are listed in table 1. Fused silica, as a reference material, was measured in the same manner to determine the relationship between the contact depth of the indenter into the test sample and the projected contact area, and the obtained data was used to calibrate the measurement data from the test sample.

<Bonding of Cover Member>

The cover member was bonded to the section obtained by cutting the glass substrate with the partition layer formed thereon, to produce a microchannel chip. In this process, the bonding surfaces of the partition layer and the cover member were subjected to surface modification treatment (10000 mJ/cm$^2$) by UV treatment, and then the bonding surfaces were brought into contact with each other and bonded together by thermal treatment on the hot plate.

For a cover member formed from silicone rubber, polyurethane, and polyvinyl chloride, a metal plate with a mass of 800 g (converted pressure: 0.00418 MPa) was placed on the cover member as a weight in order to prevent misalignment of the bonding surfaces, which were then bonded together by thermal treatment.

For a cover member formed from polyethylene terephthalate, polycarbonate, polymethyl methacrylate, and cycloolefin polymer, the bonding surfaces were bonded together while applying a load of 500 kg (converted pressure: 2.61 MPa) with a hot press in order to achieve full surface contact between the bonding surfaces.

The thermal treatment temperature was not higher than the heat-resistant temperature of each resin material. Specifically, for a silicone rubber resin material, the thermal treatment conditions were 200°C for ten minutes. For polyurethane, the conditions were 100°C for ten minutes. For polyvinyl chloride, the conditions were 60°C for ten minutes. For polyethylene terephthalate, polycarbonate, polymethyl methacrylate, and cycloolefin polymer, the conditions were 60°C for ten minutes.

<Evaluation of Gap and Distance between Substrate and Cover Member>

For the microchannel chips in Examples 1 to 12 and Comparative Examples 1 to 11, produced as described above, the interface between the resin layer and the cover member was observed under a microscope to examine whether a gap was present. Specifically, the microchannel chip was observed through the cover member using an optical microscope to determine whether a gap was present. In addition, the distance between the substrate and the cover member across the flow channel was measured using the microscope. The results are listed in table 1.

In table 1, the absence of a gap at the interface between the resin layer and the cover member is marked as OK (no gap), the presence of a slight gap is marked as OK (slight gap), and the presence of a wide gap is marked as NG. Table 1 also presents the evaluation results of the distance between the substrate and the cover member across the flow channel, and a distance within the tolerance of ±5% (±2.5 $\mu$m) from 50 $\mu$m, which is the designed distance, is marked as OK, while a distance exceeding the tolerance of +5% (+2.5 $\mu$m) from 50 $\mu$m, which is the designed distance, is marked as NG.

As used herein, the slight gap refers to a gap at the interface between the resin layer and the cover member caused by lifting of the cover member along the edge over a distance of 1 μm or less. The wide gap refers to a gap at the interface between the resin layer and the cover member caused by lifting of the cover member along the edge over a distance of more than 1 μm. The slight gap is determined as OK because it does not result in water ingress in the liquid injection test described below.

<Liquid Injection Test>

The microchannel chips in Examples 1 to 12 and Comparative Examples 1 to 11 produced as described above were subjected to a liquid injection test. That is, water was injected into the flow channel in the microchannel chip via the inlet with a pipetter, and an observation was made to determine whether the water entered the interface between the resin layer and the cover member. The results are listed in table 1. In table 1, the absence of water ingress into the interface between the resin layer and the cover member is marked as OK, and even the slightest water ingress is marked as NG.

[Table 1]

| | Resin material | Reduced modulus (MPa) | Hardness (MPa) | Degree of stress relief (%) | Gap | Water ingress | Distance between cover material and substrate |
|---|---|---|---|---|---|---|---|
| Comp. Ex. 1 | Silicone rubber | 0.55 | 0.04 | 8 | OK (no gap) | OK | NG |
| Comp. Ex. 2 | Silicone rubber | 0.82 | 0.07 | 9 | OK (no gap) | OK | NG |
| Comp. Ex. 3 | Silicone rubber | 1.20 | 0.10 | 7 | OK (no gap) | OK | NG |
| Ex. 1 | Silicone rubber | 1.68 | 0.12 | 15 | OK (no gap) | OK | OK |
| Ex. 2 | Silicone rubber | 2.98 | 0.23 | 12 | OK (no gap) | OK | OK |
| Ex. 3 | Silicone rubber | 3.20 | 0.31 | 8 | OK (slight gap) | OK | OK |
| Ex. 4 | Silicone rubber | 4.72 | 0.51 | 10 | OK (no gap) | OK | OK |
| Ex. 5 | Silicone rubber | 5.92 | 0.66 | 10 | OK (no gap) | OK | OK |
| Ex. 6 | Polyurethane | 8.11 | 0.67 | 9 | OK (slight gap) | OK | OK |
| Ex. 7 | Polyurethane | 11.27 | 1.36 | 16 | OK (no gap) | OK | OK |
| Ex. 8 | Silicone rubber | 16.46 | 1.36 | 17 | OK (no gap) | OK | OK |
| Ex. 9 | Silicone rubber | 19.04 | 1.42 | 19 | OK (no gap) | OK | OK |
| Ex. 10 | Silicone rubber | 25.22 | 2.19 | 22 | OK (slight gap) | OK | OK |
| Ex. 11 | Polyvinyl chloride | 39.20 | 1.91 | 21 | OK (slight gap) | OK | OK |
| Ex. 12 | Polyvinyl chloride | 44.30 | 1.94 | 11 | OK (no gap) | OK | OK |

(continued)

|  | Resin material | Reduced modulus (MPa) | Hardness (MPa) | Degree of stress relief (%) | Gap | Water ingress | Distance between cover material and substrate |
|---|---|---|---|---|---|---|---|
| Comp. Ex. 4 | Polyurethane | 56.20 | 4.40 | 16 | NG | NG | OK |
| Comp. Ex. 5 | Polyurethane | 59.60 | 4.80 | 18 | NG | NG | OK |
| Comp. Ex. 6 | Polyvinyl chloride | 80.10 | 6.60 | 19 | NG | NG | OK |
| Comp. Ex. 7 | Polyvinyl chloride | 102.00 | 9.00 | 18 | NG | NG | OK |
| Comp. Ex. 8 | PMMA | 4616 | 221 | 18 | NG | NG | OK |
| Comp. Ex. 9 | PET | 2586 | 108 | 19 | NG | NG | OK |
| Comp. Ex. 10 | PC | 2989 | 140 | 17 | NG | NG | OK |
| Comp. Ex. 11 | COP | 3096 | 465 | 18 | NG | NG | OK |

As shown in table 1, in cases where the reduced modulus or the hardness of the resin material forming the cover member was greater than the above-described conditions (Comparative Examples 4 to 11), a gap formed at the interface between the resin layer and the cover member. As a result, water ingress into the gap formed at the interface between the resin layer and the cover member was observed at a liquid injection test. In contrast, in cases where the reduced modulus or the hardness of the resin material forming the cover member was smaller than above-described conditions (Comparative Examples 1 to 3), warping of the cover member caused the distance between the substrate and the cover member across the flow channel to become more than 5% smaller than the designed value, reducing the volume of the flow channel compared with the design. These results show that when the reduced modulus or the hardness of the resin material forming the cover member does not satisfy the above-described conditions, the flow channel loses or partially loses its function.

Even in cases where the reduced modulus or the hardness of the resin material forming the cover member satisfied the above-described conditions (Examples 1 to 12), without the degree of stress relaxation satisfying the above condition (Examples 3, 6, 10, and 11), a slight gap formed at the interface between the resin layer and the cover member. However, since the gap was slight, no water entered at the liquid injection test.

For the microchannel chips in which the resin material forming the cover member has a reduced modulus of 1.68 MPa or more and 44.3 MPa or less or a hardness of 0.12 MPa or more and 1.94 MPa or less, no gap that could permit liquid ingress formed at the interface between the resin layer and the cover member. The distance between the substrate and the cover member across the flow channel was consistent with the designed value (falling within ±5% of the designed value).

[Reference Signs List]

1      Inlet
2      Outlet
3      Flow channel
10     Substrate
20     Partition layer
30     Cover member
41     Protrusion
51     Photosensitive resin layer
52     Exposed area
53     Unexposed area

**Claims**

1.  A microchannel chip comprising:

    a substrate;
    a partition layer provided on the substrate and defining a flow channel; and
    a cover member provided on a surface of the partition layer, the surface being opposite to a surface in contact with the substrate, wherein
    the cover member is formed from a resin material, and the resin material has a reduced modulus of 1.68 MPa or more and 44.3 MPa or less as measured by nanoindentation.

2.  A microchannel chip comprising:

    a substrate;
    a partition layer provided on the substrate and defining a flow channel; and
    a cover member provided on a surface of the partition layer, the surface being opposite to a surface in contact with the substrate, wherein
    the cover member is formed from a resin material, and the resin material has a hardness of 0.12 MPa or more and 1.94 MPa or less as measured by nanoindentation.

3.  The microchannel chip according to claim 1, wherein
    the resin material has a degree of stress relaxation of 10% or more and 19% or less as measured by nanoindentation.

4.  The microchannel chip according to claim 2, wherein
    the resin material has a degree of stress relaxation of 10% or more and 19% or less as measured by nanoindentation.

5.  The microchannel chip according to any one of claims 1 to 4, wherein
    the resin material contains at least one of polydimethylsiloxane, silicone rubber, polyurethane, and polyvinyl chloride.

6.  The microchannel chip according to any one of claims 1 to 4, wherein
    the partition layer comprises a photosensitive resin photosensitive to light in an ultraviolet region at wavelengths of 190 nm or more and 400 nm or less.

7.  A microchannel chip production method comprising:

    an application step for applying a photosensitive resin to a substrate;
    an exposure step for exposing the applied photosensitive resin;
    a development step for developing and cleaning the exposed photosensitive resin to form a partition layer defining a flow channel on the substrate; and
    a bonding step for bonding a cover member to a surface of the partition layer, the surface being opposite to the surface in contact with the substrate, wherein
    the cover member is formed from a resin material, and the resin material has a reduced modulus of 1.68 MPa or more and 44.3 MPa or less as measured by nanoindentation.

8.  A microchannel chip production method comprising:

    an application step for applying a photosensitive resin to a substrate;
    an exposure step for exposing the applied photosensitive resin;
    a development step for developing and cleaning the exposed photosensitive resin to form a partition layer defining a flow channel on the substrate; and
    a bonding step for bonding a cover member to a surface of the partition layer, the surface being opposite to the surface in contact with the substrate, wherein
    the cover member is formed from a resin material, and the resin material has a hardness of 0.12 MPa or more and 1.94 MPa or less as measured by nanoindentation.

9.  The microchannel chip production method according to claim 7, wherein
    the resin material has a degree of stress relaxation of 10% or more and 19% or less as measured by nanoindentation.

10. The microchannel chip production method according to claim 8, wherein
the resin material has a degree of stress relaxation of 10% or more and 19% or less as measured by nanoindentation.

11. The microchannel chip production method according to any one of claims 7 to 10, wherein
the exposure step exposes the photosensitive resin to light in an ultraviolet region at wavelengths of 190 nm or more and 400 nm or less.

# FIG.1

# FIG.2

# FIG.3

# FIG.4

APPLICATION STEP

EXPOSURE STEP

DEVELOPMENT STEP

BONDING STEP

# FIG.5

# FIG.6

## INTERNATIONAL SEARCH REPORT

| International application No. |
|---|
| **PCT/JP2023/044938** |

**A. CLASSIFICATION OF SUBJECT MATTER**

**B81B 1/00**(2006.01)i; **B01J 19/00**(2006.01)i; **B29C 65/48**(2006.01)i; **B81C 1/00**(2006.01)i; **G01N 37/00**(2006.01)i
FI:  B81B1/00; B01J19/00 321; B29C65/48; B81C1/00; G01N37/00 101

According to International Patent Classification (IPC) or to both national classification and IPC

**B. FIELDS SEARCHED**

Minimum documentation searched (classification system followed by classification symbols)

B81B1/00; B01J19/00; B29C65/48; B81C1/00; G01N37/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | WO 2021/182632 A1 (TOKYO INSTITUTE OF TECHNOLOGY) 16 September 2021 (2021-09-16)<br>        paragraphs [0061]-[0065], fig. 5 | 1-11 |
| Y | WO 2014/103678 A1 (ASAHI GLASS COMPANY, LIMITED) 03 July 2014 (2014-07-03)<br>        paragraphs [0015], [0036], [0112] | 1, 3, 5-7, 9, 11 |
| Y | JP 2012-84565 A (TOSHIBA LIGHTING & TECHNOLOGY CORPORATION) 26 April 2012 (2012-04-26)<br>        paragraphs [0019]-[0022], [0051] | 2, 4-6, 8, 10-11 |
| Y | JP 2019-155550 A (KABUSHIKI KAISHA TOSHIBA) 19 September 2019 (2019-09-19)<br>        paragraphs [0022], [0027]-[0028] | 6, 11 |
| Y | JP 2009-109232 A (JOSHO GAKUEN) 21 May 2009 (2009-05-21)<br>        paragraphs [0040]-[0042] | 6-11 |

✓ Further documents are listed in the continuation of Box C.    ✓ See patent family annex.

| | |
|---|---|
| \* Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **30 January 2024** | **13 February 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

## INTERNATIONAL SEARCH REPORT

| International application No. |
|---|
| **PCT/JP2023/044938** |

### C. DOCUMENTS CONSIDERED TO BE RELEVANT

| Category* | Citation of document, with indication, where appropriate, of the relevant passages | Relevant to claim No. |
|---|---|---|
| A | JP 2013-516645 A (3M INNOVATIVE PROPERTIES COMPANY) 13 May 2013 (2013-05-13)<br>entire text, all drawings | 1-11 |
| A | WO 2022/107898 A1 (TOKYO INSTITUTE OF TECHNOLOGY) 27 May 2022 (2022-05-27)<br>entire text, all drawings | 1-11 |

Form PCT/ISA/210 (second sheet) (July 2022)

**INTERNATIONAL SEARCH REPORT**
Information on patent family members

International application No.

**PCT/JP2023/044938**

| Patent document cited in search report | | | Publication date (day/month/year) | Patent family member(s) | | | Publication date (day/month/year) |
|---|---|---|---|---|---|---|---|
| WO | 2021/182632 | A1 | 16 September 2021 | US 2023/0142172 A1 paragraphs [0117]-[0121], fig. 5 | | | |
| | | | | EP 4119221 A1 | | | |
| | | | | CN 115279482 A | | | |
| WO | 2014/103678 | A1 | 03 July 2014 | CN 104903095 A | | | |
| | | | | KR 10-2015-0100688 A | | | |
| | | | | TW 201429710 A | | | |
| JP | 2012-84565 | A | 26 April 2012 | (Family: none) | | | |
| JP | 2019-155550 | A | 19 September 2019 | US 2019/0283284 A1 paragraphs [0057], [0062]-[0065] | | | |
| JP | 2009-109232 | A | 21 May 2009 | (Family: none) | | | |
| JP | 2013-516645 | A | 13 May 2013 | US 2013/0010364 A1 entire text, all drawings | | | |
| | | | | EP 2519594 A2 | | | |
| | | | | CN 102712827 A | | | |
| | | | | KR 10-2012-0112646 A | | | |
| | | | | BR 112012016335 A2 | | | |
| WO | 2022/107898 | A1 | 27 May 2022 | EP 4249109 A1 entire text, all drawings | | | |
| | | | | CN 116457079 A | | | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003060127 A
- JP 2002139419 A
- JP 2011104886 A